(19) Europäisches Patentamt
European Patent Office
Office européen des brevets

(11) **EP 4 535 965 A2**

(12) **EUROPEAN PATENT APPLICATION**

(43) Date of publication:
**09.04.2025 Bulletin 2025/15**

(21) Application number: **25158616.0**

(22) Date of filing: **20.04.2022**

(51) International Patent Classification (IPC):
**H10H 20/825** (2025.01)    **H10H 20/01** (2025.01)
**H10H 29/14** (2025.01)    **H10H 20/815** (2025.01)
**H10H 20/82** (2025.01)    **H10H 20/821** (2025.01)

(52) Cooperative Patent Classification (CPC):
**H10H 29/142; H10H 20/01335; H10H 20/018;**
**H10H 20/825;** H10H 20/815; H10H 20/82;
H10H 20/821

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **22.04.2021 EP 21169799**

(62) Document number(s) of the earlier application(s) in
accordance with Art. 76 EPC:
**22723631.2 / 4 327 365**

(71) Applicant: **Epinovatech AB**
**223 63 Lund (SE)**

(72) Inventor: **OLSSON, Martin Andreas**
**223 63 Lund (SE)**

(74) Representative: **Zacco Sweden AB**
**P.O. Box 5581**
**Löjtnantsgatan 21**
**114 85 Stockholm (SE)**

Remarks:
This application was filed on 18.02.2025 as a
divisional application to the application mentioned
under INID code 62.

(54) **MICROSCOPIC LIGHT-EMITTING DIODE, MICROLED, STRUCTURE AND A LED MATRIX COMPRISING A PLURALITY OF SUCH MICROLED STRUCTURES**

(57)    A microscopic light-emitting diode, microLED, structure is provided. The microLED structure comprises a LED element (11, 21, 31). The LED element (11, 21, 31) comprises a base formed as a polyhedron comprising a base surface and a plurality of oblique surfaces extending between the base and an apex, the base being formed of GaN and constitutes a first GaN layer (111, 121, 131); a second GaN layer (113, 123, 133); and an InGaN layer (112, 122, 132) arranged between the first GaN layer (111, 121, 131) and the second GaN layer (113, 123, 133). Either the first GaN layer (111, 121, 131) is n-doped and the second GaN layer (113, 123, 133) is p-doped, or the first GaN layer (111, 121, 131) is p-doped and the second GaN layer (113, 123, 133) is n-doped. A LED matrix (100) comprising a plurality of microLED structures is also provided.

Fig. 16

**Description**

TECHNICAL FIELD

The present inventive concept generally relates to gallium nitride, GaN,-based light emitting diodes, LEDs, and in particular to microscopic light-emitting diodes, microLEDs, structures comprising GaN. A LED matrix comprising a plurality of such microLED structures is also presented.

BACKGROUND

GaN-based LEDs have attracted attention in recent years, not at least as a potential replacement for conventional LEDs forming RGB pixels in display devices. The GaN-based LEDs may include a quantum heterostructure formed of GaN with an active layer of indium gallium nitride, InGaN, providing the quantum confinement regions. The InGaN layer may be formed of a mixture of GaN and indium nitride, InN, and the wavelength of the light emitted by the InGaN layer can be tuned by varying the GaN/InN ratio and also by controlling the thickness of the InGaN layer.

Conventionally, GaN-based LEDs may be manufactured by means of epitaxial growth followed by chip fabrication, wafer dicing and pick-and-place robotic manipulation into individually packaged components that can be interconnected by bulk wire-bonding. However, the conventional back-end processing becomes more difficult with the overall strive for miniaturisation and scaling of semiconductor devices. A different approach has therefore been suggested, in which the LEDs are formed on a substrate, separated from each other by etching, and transferred to a carrier wafer in a lift-off process. The LEDs may be separated from the substrate by means of laser lift-off or chemical lift off and transfer-printed onto a destination substrate.

This fabrication method is however known to require a series of relatively expensive and complicated processing steps, and it would therefore be desirable to provide alternative and more efficient manufacturing methods.

There are also several technical challenges associated with reducing the size of the LEDs. Microscopic LEDs may for example suffer from issues related to full-colour operation, reduced external quantum efficiency, EQE, low-efficiency and low-yield mass transfer. Further, microscopic LED epitaxy may require improvement of wavelength and thickness uniformity. Uniform wavelengths and thickness are desirable for chips less than 100 micrometres. In addition, power leakage may occur due to non-uniformity caused by the cutting damage around the LED chip, which may affect the overall luminescence characteristics. The driving current should preferably be relatively low and inspection and testing of quality assurance is in general more difficult for smaller chip sizes. In particular, mass transfer manufacturing processes where LED chips are transferred to a non-epitaxial substrate, is a major technical challenge. For full-colour RGB chips, colour conversion may be associated with insufficient luminance yield problems, especially for chips of a size less than 20 micrometres. Other issues may be low EQE of microLEDs.

SUMMARY

An objective of the present inventive concept is to wholly or partly overcome one or more of the drawbacks of the prior art and to provide an improved alternative to the above technique. This and further objectives may be understood from the following.

The invention is defined in the appended set of claims.

According to a first aspect there is provided a method for forming a first array of first LED elements, a second array of second LED elements, and a third array of third LED elements, wherein the first, second and third arrays form a matrix of LED elements capable of emitting light of different colours. The first, second and third arrays of LED elements are formed by means of epitaxial growth on a sacrificial layer comprising GaN.

Thus, the method comprises epitaxially growing a first layer on the GaN sacrificial layer, wherein the first layer comprises a stacked structure of a first n-doped GaN layer, a first p-doped GaN layer, and a first $In_xGa_{(1-x)}N$ layer arranged therebetween, wherein x lies within the range of 0.10-0.75. The first layer may then be patterned to form the first array of first LED elements arranged to emit light of a first colour, followed by forming a first etch mask protecting the first array and having a plurality of first trenches exposing the sacrificial layer. The first etch mask may be formed by depositing a layer of a mask material covering the first array and the sacrificial layer and patterning the layer to form the trenches exposing the sacrificial layer. Thereafter, the second array of second LED elements may be epitaxially grown in the plurality of first trenches. The second LED elements are arranged to emit light of a second colour and comprises a stacked structure of a second n-doped GaN layer, a second p-doped GaN layer, and a second $In_yGa_{(1-y)}N$ layer arranged therebetween, wherein y lies within the range of 0.20-0.28. Further, the method comprises forming a second etch mask protecting the second array and comprising a plurality of second trenches exposing the sacrificial layer. The second etch mask may be formed by covering the second array of second LED elements with a mask material and patterning the first mask layer to form the plurality of second trenches. Thereafter, the third array of third LED elements may be epitaxially grown in the plurality of second trenches. The third LED elements are arranged to emit light of a third colour and comprises a stacked structure of a third n-doped GaN layer, a third p-doped GaN layer, and a third $In_zGa_{(1-z)}N$ layer arranged therebetween, wherein z lies within the range of 0.28-0.33.

The present method allows for an integrated processing of LED elements of different colour. As outlined in connection with the first aspect, there is provided a technique for forming a matrix comprising the first, second and third LED elements on the same GaN sacrificial layer. This may be achieved by the sequential processing involving epitaxial growth, patterning and masking. More specifically, the first LED elements may be protected by the first etch mask during the processing of the second and third LED elements, and the second LED elements protected by an additional mask material during the processing of the third LED elements. Further, the dimensions and layout of the various LED elements may be determined by the patterning of the first layer and definition of the first and second trenches. The LED elements may also be referred to as microLEDs, referring to the relatively small size of the individual elements. The resulting matrix may thus be a monolithic LED device, in which LED elements of different colours may be produced on the same substrate. The LED elements may for example be configured to emit red, green and blue light as specified in the RGB colour model, thereby allowing for the matrix to form RGB pixels for a display device. Combining the different colours on the same substrate is advantageous over prior art techniques, in which LED elements of different colours may be formed in separate processes and on separate substrates, and then combined into pixels in a back-end process.

The sequential epitaxial growth of the first, second and third LED elements allows for the composition of the active layer, i.e., the In content of the quantum confinement region formed by the InGaN layer, to be varied between the first, second and third LED elements in order to control the wavelength of the emitted light. The thickness of the active layer may also be varied so as to further affect the wavelength of the emitted light. The first, second and third thicknesses mentioned above may hence be varied depending on the desired wavelength range, or colour of the light emitted from the resulting LED element. The same applies to the first, second and third ranges for the variables x, y and z, respectively, which also may be varied according to the desired light output.

While the epitaxy process may be varied and controlled so as to affect the wavelength of the emitted light, the patterning of the first layer and the definition of the first and second trenches may be controlled so as to vary the lateral dimensions of the first, second and third LED elements, respectively. The lateral dimensions, such as the maximum width and preferably the area of the LED elements, may be varied so as to control and balance the luminance of the different LED elements. In an example, the first LED elements may comprise micrometre-sized quantum confinement regions forming quantum wells (for example emitting light within the blue wavelength range), whereas the second and third LED elements may be formed of quantum dots, i.e., quantum confinement regions having a width of a few nanometres, such as less than 10 nanometres (for example emitting light within the red and green wavelength range, respectively). The lateral dimensions of the quantum confinement regions of the second and third LED elements may be determined by the width of the first and second trenches, which for example may be formed in the first mask layer by means of nanoimprint lithography.

The arrays, which may be one-dimensional or two-dimensional, may be provided in various layouts and configurations that allow for the first, second and third LED elements of the matrix to form individually controllable sub-pixels of the pixels of a display device. A sub-pixel, which thus could be understood as a controllable entity of a single colour such as red, blue or green, may in other words be formed of one or several LED elements of the first, second or third colour. Examples of array layouts and LED element dimensions will be discussed in more detail in connection with the detailed description of the drawings.

As used herein, the term "lateral" denotes a direction or plane being parallel to a main plane of extension of the above-mentioned layers. The matrix and the sacrificial layer may be supported by a substrate during the processing, wherein the term "lateral" direction or "lateral" plane equivalently may be understood as a direction parallel to a main plane of extension of the substrate.

As used herein, the term "vertical" direction or "vertical" plane denotes a direction or plane being perpendicular to a horizontal direction or horizontal plane. I.e. the term "vertical" direction or "vertical plane" denotes a direction or plane being perpendicular to a main plane of extension of a substrate supporting the matrix and the sacrificial layer.

Accordingly, the terms "above" and "below" refer to directions along the vertical direction and opposite to the vertical direction, respectively.

A layer or structure that is arranged directly adjacent on another structure or layer may be understood as being arranged above the other structure or layer in the vertical direction and sharing a physical interface with the below structure or layer. Such a physical interface may be configured to provide or hinder conductive contact, i.e., allow charge carrier transport, across the interface. Conductive contact may refer to e.g. ohmic contact, Schottky contact, and/or contact across a pn-junction or tunnel junction.

According to an embodiment, the first $In_xGa_{(1-x)}N$ layer may have a first thickness being on average 0.5-3 nm. The second $In_yGa_{(1-y)}N$ may have a second thickness being on average 2-3 nm, and the third $In_zGa_{(1-z)}N$ layer a third thickness being on average 2.8-3.5 nm. With these dimensions a matrix may be obtained, wherein the first LED elements may be capable of emitting blue light, the second LED elements capable of emitting green light, and the third LED elements capable of emitting red light.

The light-emitting efficiency, or luminance, may vary between the first, second and third LED elements. As previously mentioned, the differences in luminance may be adjusted, or at least partly balanced, by varying the lateral extension of the LED elements. Thus, according to an embodiment, the lateral size of the first LED elements, for example characterized by the area or lateral width of the first LED elements, may be relatively large compared to the second and third LED elements. The maximum lateral width of each of the first LED elements may for example lie within the ranges of 0.1-1 $\mu$m, 2-5 $\mu$m or 5-25 $\mu$m, whereas the maximum lateral width of each of the second and third LED elements may be 10 nm or less. In some examples, the maximum lateral width may lie within the range of 2-3 nm for the second LED elements and 2.8-3.5 nm for the third LED elements. These lateral dimensions of the LED elements have shown to allow for the InGaN layer to form a quantum confinement region, such as a well or a dot having an improved capability of emitting a substantially monochrome light also for indium compositions that vary over the substrate.

According to an embodiment, the GaN sacrificial layer may be n-doped or p-doped. Advantageously, the GaN sacrificial layer may form the n-doped or p-doped layer of the stacked structure forming the LED elements. The first, second or third InGaN layer of the LED elements, or other layers included in the stacked structure such as e.g. barrier layers, may hence be epitaxially grown directly on the n-doped or p-doped GaN layer.

According to an embodiment, the matrix may be configured to form a plurality of pixels for a display device. Each pixel may be formed of at least one of the first LED elements and a plurality of the second and third LED elements. In other words, a pixel may comprise a first subpixel formed of at least one of the first LED elements, a second subpixel formed of a group of the second LED elements and a third subpixel formed of a group of the third LED elements. In an example, each of the group of the second and third LED elements may have a footprint that is substantially the same as the footprint of the first subpixel. It may be advantageous to use a plurality of LED elements for the second and third subpixel and only one or a few LED elements for the first subpixel so as to balance differences in luminance between the first colour and the second and third colours.

According to an embodiment, the first colour may be blue, the second colour green and the third colour red so as to allow a pixel to be formed, which follows the RGB colour model commonly used in image-producing technology.

According to an example, an AlGaN barrier layer may be formed on opposite sides of at least one of the first $In_xGa_{(1-x)}N$ layer, the second $In_yGa_{(1-y)}N$ layer and the third $In_zGa_{(1-z)}N$ layer. The AlGaN barrier may be arranged directly adjacent the InGaN layer, i.e. forming a junction or interface with the InGaN layer, and thereby act as a barrier structure for confining positive (hole) charge carriers in the active layer. AlGaN is known to have a wider bandgap than InGaN alloys and may hence serve as a potential barrier for hindering tunnelling electrons from tunnelling to the outside of the quantum confinement region formed by the InGaN layer. The AlGaN barrier layer may be formed in the epitaxial growth of at least one of the first, second and third LED elements, for example by epitaxially growing a first barrier layer immediately prior to growing the InGaN layer, and a second barrier layer immediately after the growing of the InGaN layer.

According to an example, an undoped GaN layer may be formed directly adjacent at least one of the AlGaN barrier layers, such that the AlGaN barrier layer is arranged between the InGaN layer and the undoped GaN layer. The undoped GaN layer may be provided to hinder the quality of the modulation-doping of the InGaN layer from being deteriorated.

According to an embodiment, at least one of the first etch mask and the second etch mask may be a hardmask. The hardmask may for example be formed of a deposited oxide or nitride material, or by a spin-on material. Preferably, the hardmask may be capable of withstanding multiple patterning processes, involving formation of the first and second trenches and the epitaxial growth associated therewith. Thus, the second etch mask may be formed by covering the second array of LED elements with a mask material, such as the above oxide or nitride material, and by etching the plurality of second trenches in the layer forming the first etch mask. The first etch mask and the second etch mask may hence be formed in the same layer of etch mask material.

The quantum confinement region formed by the InGaN layer arranged between the p-doped and the n-doped GaN layers, is not necessarily limited to planar structures. The InGaN layer may for example be arranged on oblique surfaces, such as the sides of a pyramidal structure, which for example may be formed on, or by, the underlying p-doped or n-doped GaN layer. Further, the quantum confinement region formed by the InGaN layer may be provided in other shapes and structures than planar layers. The quantum confinement region may for example be formed as a quantum well confining carriers in one dimension, a quantum wire confining carriers in two dimensions or a quantum dot confining carrier in all three dimentions. Structurally, the InGaN layer may according to some be provided as pillars or pyramids, as will be discussed further in the detailed description.

Further, it will be appreciated that the stacked structure forming the LED elements may comprise more than one InGaN layer. The LED elements may therefore comprise a multi-quantum well formed by a plurality of InGaN layers.

According to an embodiment, a fourth LED element, such as an ultraviolet (UV) LED element, may be formed beneath at least one of the first, second or third LED elements. The fourth LED element may be provided for used for optical pumping of the LED element above. The fourth LED element may comprise a fourth $In_dGa_{(1-d)}$

N layer with an indium composition corresponding to d being less than 0.05. Further, the layer thickness may lie in the range of 1-6 nm. The fourth LED element may in some examples comprise a multi-quantum well (MQW). The fourth LED element may be combined with any of the embodiments discussed above and may be formed by similar processes as the first, second and third LED elements. Thus, the fourth LED element may be formed by means of epitaxy of a stacked structure comprising an n-doped GaN layer and a p-doped GaN layer with the active, fourth $In_dGa_{(1-d)}N$ layer therebetween. As outlined above, additional barrier layers comprising e.g. AlGaN and/or undoped GaN may also be provided to the stacked structure.

It will be appreciated that the term "LED elements" as used in the present application may refer to the combined structure of a first (or second or third) LED element and an underlying, fourth LED element as outlined above. Thus, the term LED element may in some embodiments refer to an optically pumped version of any of the first, second and third LED elements.

According to an embodiment, the GaN sacrificial layer may be arranged on a substrate having a layer comprising a plurality of pillars embedded by the material of the GaN sacrificial layer. The pillars may be arranged under the LED elements, as seen in the vertical direction. The pillars may be adapted to mechanically support the LED elements after etching of the GaN sacrificial layer, and may in other words be configured to tether or anchor the LED elements to the underlying substrate after the GaN sacrificial layer has been at least partly removed. Preferably, the pillars may be formed of a material that is sufficiently etch-selective to the GaN so as to allow the LED elements to be released from the GaN sacrificial layer. In an example, the pillars may be formed of AlN, which has showed to be possible to etch with a sufficiently high selectivity to GaN.

According to an embodiment, a plurality of third trenches may be formed between at least some of the first, second and third LED elements. The third trenches may for example be arranged to define, or delimit, a subpixel comprising one or several LED elements of the same colour. The third trenches may be etched down to the layer comprising the plurality of pillars, so as to allow a least some of the GaN sacrificial layer to be selectively removed with respect to the pillars. After the etch of the GaN sacrificial layer the substrate may now comprise a plurality of pillars supporting a plurality of LED elements, which may be grouped into subpixels comprising one or several LED elements of the same colour.

According to an embodiment, the first, second and third LED elements, supported by the pillars, may be attached or bonded from above to a carrier substrate. In a subsequent step, the first, second and third LED elements may be released from the substrate by removing or breaking the pillars. The pillars may for example be removed by etching.

The pillars may hence be used to tether the matrix formed by the first, second and third array of LED elements to the substrate, or native substrate, prior to transfer. The pillars may support the LED elements, which may be lattice-unmatched to the substrate, during the attachment to the carrier wafer, and reduce the risk of wafer bow due caused by lattice and coefficient of thermal expansion mismatch between the substrate and the LED elements.

In alternative embodiments, the pillars may be kept under the LED elements to increase the light extraction from the LED elements. The pillars may in that case be used to facilitate scattering of the light emitted by the LED elements.

Further, the present embodiments allow for the LED elements to be produced monolithically on silicon for state-of-the-art CMOS backplane processing provided by silicon CMOS fabs. Preferably, the carrier may be a 6-inch silicon wafer or larger. Alternatively, the LED elements may be transferred to a glass substrate. Such glass displays may be used as the front windshield or passenger windows of an electric vehicle.

In one example the matrix may be transferred to a glass substrate to form a glass LED display. Such a glass LED display may be provided as the front windshield of a vehicle, such as an electric vehicle. The LED elements may allow for the windshield to display GPS instructions to the driver as augmented reality information, e.g. visually displaying a right or left turn 200 m down the road while driving. Furthermore, the glass LED display may show various infotainment to the driver while driving. Preferably, the electroluminescence may be relatively high in order to provide the augmented reality information in daylight. The glass LED display may also provide assistance in highlighting objects close by as a heads up to the driver, such as a warning indicating that a pedestrian is walking on the road or that a bicycle is about to collide with the vehicle without if no further actions are taken.

In another example the LED matrix may be an ultra-high definition (UHD) 8K display processed from a silicon wafer having a GaN buffer layer. The display may have a resolution of 7680 × 4320 with 33 177 600 pixels. Similarly, a LED matrix with a resolution of UHD 4K may be processed with a resolution of 3840 × 2160 having a pixel count of 8 294 400.

BRIEF DESCRIPTION OF THE DRAWINGs

The above, as well as additional objects, features and advantages of the present inventive concept, will be better understood through the following illustrative and non-limiting detailed description, with reference to the appended drawings. In the drawings like reference numerals will be used for like elements unless stated otherwise.

Figures 1-12 are cross sections schematically illustrating a method for forming a matrix of LED elements of different colours.

Figure 13 is a top view of such a matrix, illustrating the arrangement of the arrays of LED elements.

Figures 14-16 are cross sections of LED elements according to some embodiments.

It should be noted that the illustrated structures and layers may extend laterally beyond the illustrated portions. It should further be noted that, owing to the schematic nature of the drawings, the relative dimensions of the various structures and layers are not drawn to scale. Rather, the dimensions have been adapted for illustrational clarity and to facilitate understanding of the following description.

DETAILED DESCRIPTION

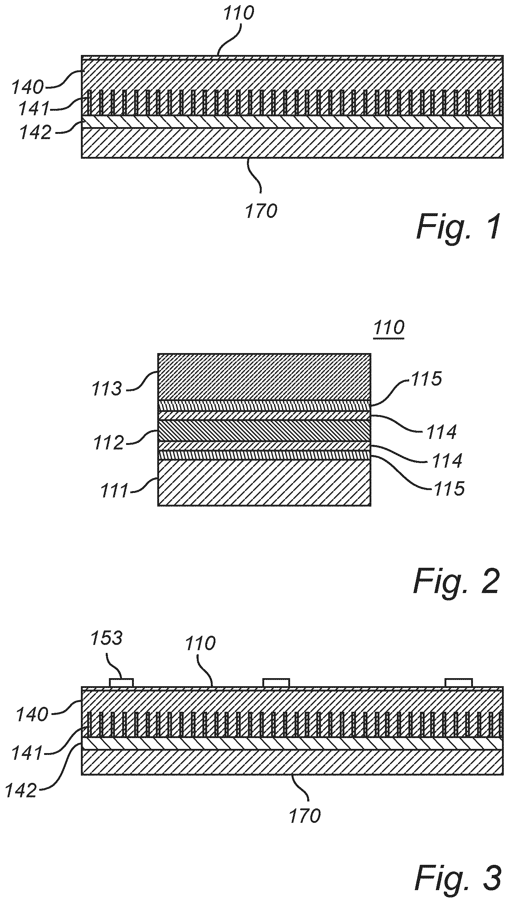

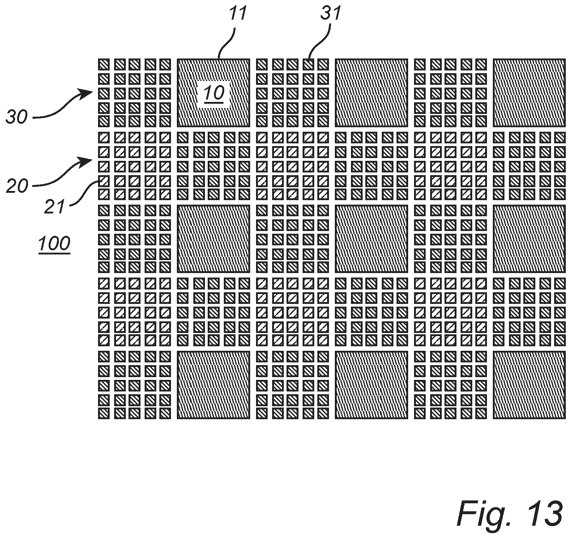

A method for forming a matrix 100 of LED elements 11, 21, 31 as shown in figure 13 will now be described with reference to figures 1-12. As may be understood, a sub-set of the following method steps may be performed to form a matrix as shown in figure 13.

In figure 1, a sacrificial layer 140 of GaN has been formed on a substrate 170. The substrate 170 may for example be a silicon (111) substrate. Further, a pillar layer 142, comprising a plurality of vertical pillars 141, may be provided on the substrate 170 such that the pillars 141 are embedded in the GaN sacrificial layer 140. The pillars 141 may for example be formed by epitaxially growing an AlN layer 142 on the substrate 170, followed by lithographic patterning and etching of the AlN layer 142 into a plurality of micropillars 141 protruding from a surface of the AlN layer 142. The pillars may for example have a thickness of 100 nm or less and may be arranged in a hexagonal pattern with a pitch or separating distance of 400 nm between adjacent pillars. Figure 1 shows an example of the resulting structure, in which the plurality of pillars 141 are embedded in the GaN sacrificial layer 140. The GaN sacrificial layer 140 may be formed by epitaxial growth.

A first layer 110 may be formed above the sacrificial layer 140, such as indicated in figure 1. The first layer 110 may be epitaxially grown on the sacrificial layer 140 and may comprise a stacked structure from which the first LED elements of the matrix are to be defined, as will be illustrated in the following figures. The stacked structure may form a quantum heterostructure formed of a first and a second doped GaN layer with an active layer of InGaN arranged therebetween. The InGaN may be a mixture of GaN and InN, having a bandgap that can be tuned by varying the GaN/InN ratio and also by controlling the thickness of the InGaN layer so as to allow the InGaN layer to emit light within a certain wavelength range.

An example of such a stacked structure is illustrated in figure 2, showing a portion of the first layer 110 in figure 1. The stacked structure may comprise a first n-doped GaN layer 111 arranged on the GaN sacrificial layer 140, a first p-doped GaN layer 113 arranged above the first n-doped GaN layer 111, and a first $In_xGa_{(1-x)}N$ layer 112 arranged between the first n-doped GaN layer 111 and the first p-doped GaN layer 113. The GaN may be intrinsically doped or doped with silane. For the p-doping a flow of $Mg_3N_2$, preferably of 100-250 sccm, may be used during the epitaxy process.

The order of the n-doped GaN layer and the p-doped GaN layer may in some examples be switched, such that the first p-doped GaN layer 113 is arranged below the first $In_xGa_{(1-x)}N$ layer 112 and the first n-doped GaN layer 111 is arranged above the $In_xGa_{(1-x)}N$ layer 112. Additional layers, such as an AlGaN barrier 114 and an undoped GaN layer 115 may also be added to the stacked structure, which will be discussed in further detail later.

Preferably, the layers of the stacked structure may be formed by means of epitaxy and may thus be referred to as epitaxial layers or epilayers. The epitaxy process may be initiated on the GaN sacrificial layer 140 and the epitaxial layers may hence have a crystal orientation that is determined in relation to of the orientation of the GaN sacrificial layer 140. The stacked structure may be grown using a vapour-phase based epitaxy process, in which the composition of the reactants may be varied so as to provide the different layers of the stacked structure.

In an example, a close coupled showerhead metalorganic chemical vapour deposition (CCS MOCVD) reactor may be used, which may allow for the composition and dimensions of the stacked structure to be controlled over relatively large surfaces, such as 6-inch wafers or larger wafers. The CCS MOCVD reactor may further be used for controlling the in-situ doping levels of the p- and n-doped GaN layers. This type of reactor has shown to be capable of providing an epitaxial growth rate that is substantially linear to the total flow of the reactants. The thickness of the boundary layer $\delta$, in which gases may diffuse to the substrate, may be independent of the radial distance from a central stagnation point. This has shown to be particularly advantageous for the processing of relatively large substrates, such as 6- or 12-inch wafers. The boundary layer $\delta$, in which the reactants begin to diffuse to the substrate, may be quantified as as $\delta \sim \sqrt{Re_{vert}}$ where $Re_{vert}$ is the Reynolds number for the vertical flow to the substrate. Furthermore, the Reynolds number can be written as

$$Re_{vert} = \frac{\rho u D^2 / H}{\mu}$$

, where $u$ is the flow rate, $D$ is the chamber diameter, $H$ is the chamber height, $\rho$ is the gas density and $\mu$ is the dynamic viscosity of the gases.

A further advantage of using a CCS MOCVD reactor is that when the reactor volume is scaled up, the effect of hot steam circulation near the hot reactor walls may decrease, which has shown to be favorable for achieving the same epitaxial growth conditions over the entire wafer surface. Thus, high reproducibility may be achieved at predetermined locations on relatively large wafer surfaces. The concentration gradient of the reacting 3-component system for In, Ga and N may arise from the limitation of one reactant for reaction. By reducing the thickness of the boundary layer in the reactor, the composition of InGaN can be controlled for fine-tuning the color quality of the resulting LED elements. The bandgap of the InGaN layer may further be modified by varying the thickness of the quantum confinement region formed by the InGaN layer. The thickness of the quantum confinement region may be controlled by the flow of V precursor that reacts with a III-precursor.

Varying the thickness of the InGaN layer may further be advantageous when producing red coloured LED elements. The indium ratio in the InGaN alloys forming the InGaN layer may vary slightly over the wafer inside the reactor chamber during the growth of the InGaN layer. This may be a potential issue for highly indium-rich compositions, which also tend to phase segregate. The production of red colour LED elements, which are associated with bandgaps resulting from highly indium-rich compositions, may therefore be challenging to control in practice. Confining the thickness of the InGaN layer may provide a further means for controlling the colour quality. By relaxing the constraint on indium composition, the preferred thickness of the InGaN epilayer for red LED elements may be around 3 nm, for green LED elements about 2.5 nm and for blue LED elements about 2 nm. For these examples, the composition may vary up to 1-2% with still negligible effects on the colour of the LED elements.

In the present example shown in figure 2, the first layer 110 may be formed by first growing the n-doped GaN layer 111 on the surface of the sacrificial layer 140, then growing the first $In_xGa_{(1-x)}N$ layer 112 on the first n-doped GaN layer 111, followed by growing the first p-doped GaN layer 113 on the first $In_xGa_{(1-x)}N$ layer 112. The thickness of the first $In_xGa_{(1-x)}N$ layer 112 may be 0.5-3 nm, and the In ratio may be determined by x being within the range of 0.10-0.75.

Additional layers may be provided to the stacked structure so as to further improve the performance of the resulting LED element. The additional layers may preferably by formed by the same epitaxy process as the rest of the stacked structure, such as in the CCS MOCVD reactor discussed above.

In an example, a layer of AlGaN 114 may be provided on opposite sides of the InGaN layer. AlGaN is known to have a wider bandgap than InGaN and may therefore serve as a potential barrier hindering tunnelling electrons from tunnel to the outside of the quantum confinement region formed by the active layer of InGaN. The AlGaN layer 114 may hence be formed directly below and directly above the InGaN layer 112, such that a junction or interface is formed between the InGaN layer 112 and the AlGaN barrier layer 114. The AlGaN may be provided in two barrier layers 114, of which a first one may be formed by epitaxy prior to the forming of the InGaN layer 112, which hence may be grown on the AlGaN layer 114, and a second one may be epitaxially grown directly on the InGaN layer 112.

In another example, a 2-10 nm thick layer of undoped GaN 115 may be formed adjacent to one or both of the AlGaN layers 114, such that an AlGaN layer 114 is arranged between the InGaN layer 112 and the undoped GaN layer 115. The undoped GaN layer 115 may be arranged to abut the AlGaN layer 115 and may be provided so as to improve the modulation doping of the InGaN layer 112, in wherein charge carriers move to the bottom of the quantum confinement region.

Further, it will be appreciated that more than one InGaN layer 112 may be provided as well, thereby forming a multi-quantum well.

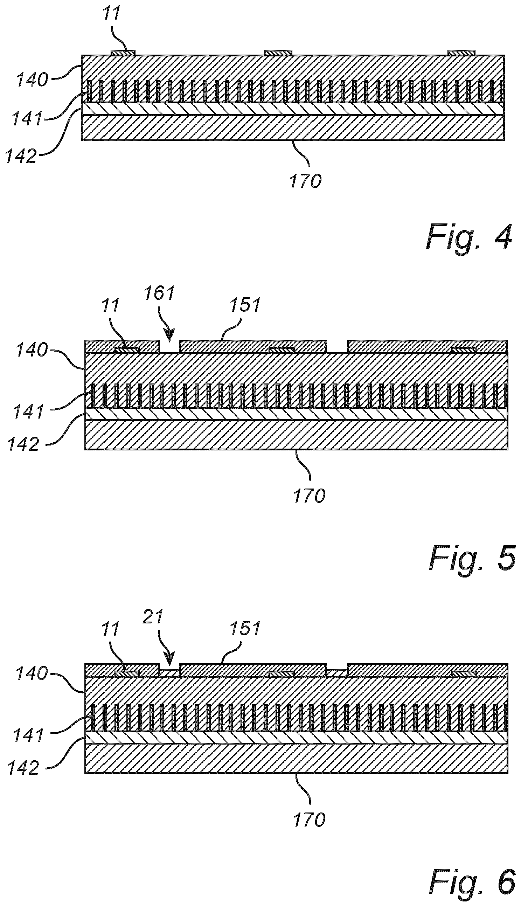

The first layer 110 may then be patterned into a first array of first LED elements 11, for example by means of the processing steps illustrated in figures 3 and 4. In figure 3 the first layer 110 has been lithographically patterned with a positive mask 153, defining the areas of the first layer 110 that is to be formed into first LED elements 11. The positive mask 153 may for example be formed of a layer of a-C, a-Si, spin-on-carbon (SOC), SiCN or photoresist, and the lithographic patterning may for example include nanoimprint lithography.

In figure 4, the pattern of the positive mask 153 has been transferred into the first layer 110 by etching while using the positive mask 153 as an etch mask protecting the areas of the first layer 110 that form the first LED elements 11. The pattern transfer may be performed by an anisotropic etch process, which for example may be a plasma-based etch process. The resulting structure, after removal of the positive mask 153, is shown in figure 4, wherein the first LED elements 11 form a first array on the sacrificial layer 140. A top view of an example of such a first array is also shown in figure 13, wherein the first LED elements 11 form a 2D-array.

In figure 5, a first etch mask 151, such as a hard mask 151, has been formed on the sacrificial layer 140 and the first LED elements 11. The first etch mask 151 may for example be a layer of a hard mask material deposited by any suitable deposition method such as physical vapour deposition (PVD) or chemical vapour deposition (CVD). Examples of hard mask materials may include nitrides such as silicon nitride and titanium nitride, and oxides such as silicon oxide and titanium oxide. In figure 5, the hard mask 151 has been patterned to include a plurality of first trenches 161 exposing the sacrificial layer 140. The trenches may be formed by means of lithographic patterning, for example using a negative mask and single or multi-patterning, followed by pattern transfer into the hard mask 151. The pattern transfer may for example be achieved by means of an anisotropic etch process. The etch process may be a plasma-based etch, including for example reactive ion etching (RIE).

The first trenches 161 may be arranged between at least some of the first LED elements 11, which hence may be covered and protected by the hard mask 151 during the subsequent processing of the second and third LED elements 21, 31. The arrangement and dimensions of the first trenches 161 may define the second array of the second LED elements 21 and their position in the resulting matrix.

In figure 6 the second array of second LED elements 21 has been formed in the plurality of first trenches 161. The second LED elements 21 may comprise a stacked structure which may be similarly configured as the one described above with reference to figures 1 and 2 and may hence be formed by an epitaxy process similar to the one used for forming the first LED elements 11. The second array of second LED elements 21, arranged in the first trenches 161, may therefore comprise a stacked structure of a second n-doped GaN layer 121, a second p-doped GaN layer 123, and a second $In_yGa_{(1-y)}N$ layer 122 arranged therebetween. In an example, the thickness of the second $In_yGa_{(1-y)}N$ layer 122 may be 2-3 nm. Further, the second $In_yGa_{(1-y)}N$ layer 122 may comprise an indium ratio determined by y being within the range of 0.20-0.28. It will be appreciated that the second LED elements 21 further may comprise one or several of the additional layers disclosed in figure 2, such as the AlGaN barrier layer 114 and/or the undoped GaN layer 115.

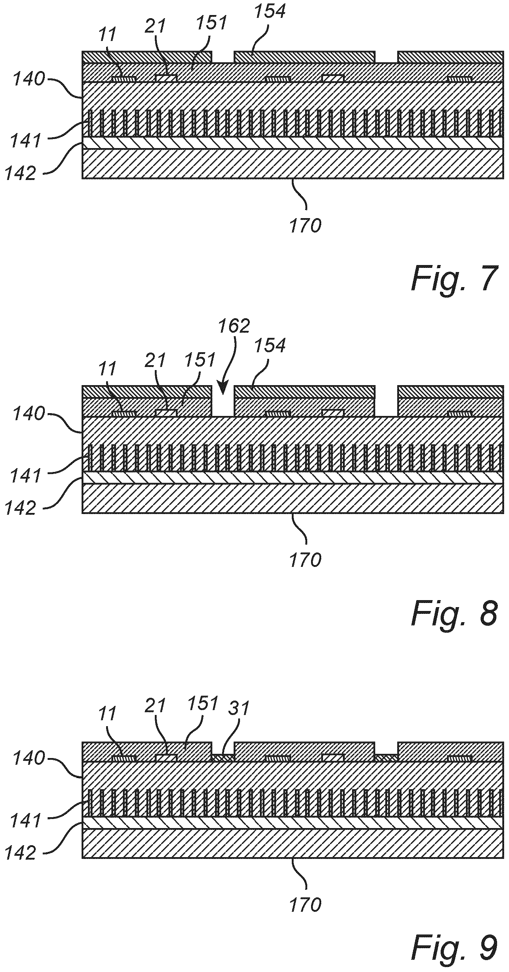

In figure 7 the first trenches 161, comprising the second LED elements 21, have been filled with a mask material, which for example may be the same material as the one forming the first mask 151. The first trenches 161 may for example be filled in a PVD or CVD process. The hard mask 151 may further be patterned to define a plurality of second trenches 162, for example by means of a lithographic mask 154 illustrated in figure 7. The definition of the second trenches 162 may be similar to the definition of the first trenches 161 discussed above, and the resulting etch mask may be referred to as a second etch mask.

In figure 8 the pattern in the lithographic mask 154 has been transferred into the hard mask 151 by a similar process as for the first trenches 161. The second trenches 162 may be arranged between at least some of the first and second LED elements 11, 21, which hence may be covered and protected by the hard mask 151 during the subsequent processing of the third LED elements 31. Similar to the first trenches 161 the arrangement and dimensions of the second trenches 162 may define the third array of the third LED elements 31 and their position in the resulting matrix.

In figure 9 the third array of third LED elements 31 has been formed in the plurality of second trenches 161 and the lithographic mask 154 stripped. The third LED elements 31 may comprise a stacked structure which may be similarly configured as the one described above with reference to figures 1, 2 and 6, and may hence be formed by an epitaxy process similar to the one used for forming the first and second LED elements 11, 21. The third LED elements 31 may therefore comprise a stacked structure of a third n-doped GaN layer 131, a third p-doped GaN layer 133, and a third $In_zGa_{(1-z)}N$ layer 132 arranged therebetween. In an example, the thickness of the third $In_zGa_{(1-z)}N$ layer 133 may be 2.8-3.5 nm. Further, the third $In_zGa_{(1-z)}N$ layer 133 may comprise an indium ratio determined by z being within the range of 0.28-0.33. It will be appreciated that the third LED elements 31 further may comprise one or several of the additional layers disclosed in figure 2, such as the AlGaN barrier layer 114 and/or the undoped GaN layer 115.

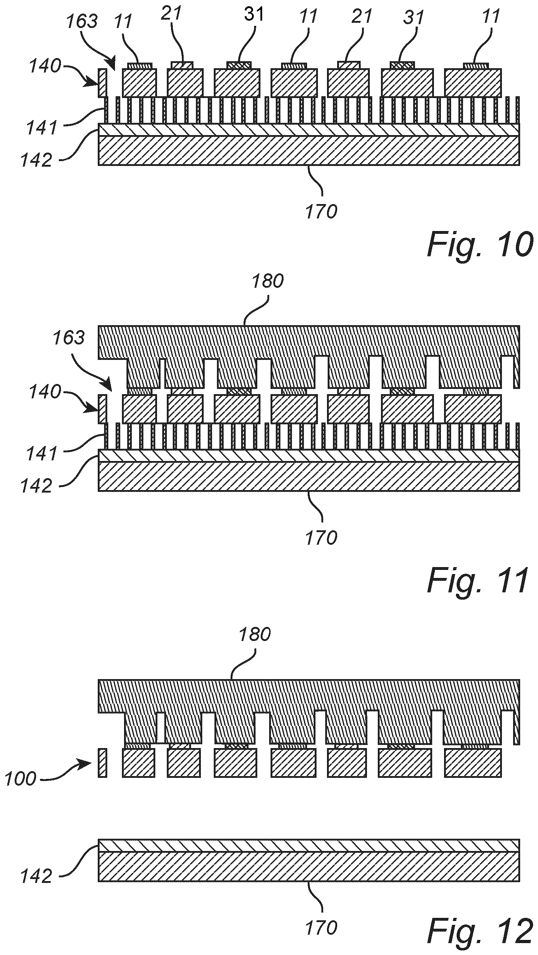

In figure 10 a plurality of third trenches 163 has been formed between at least some of the first, second and third LED elements 11, 21, 31. The third trenches 163 may be formed in a process similar to the forming of the first and second trenches 161, 162 in the first mask 151. Hence, the third trenches 163 may be formed in a process including lithography and pattern transfer into the first mask 151. The first mask 151 may in some examples then be used as an etch mask when transferring the pattern for the third trenches 163 into the GaN sacrificial layer 140 between at least some of the LED elements 11, 21, 31. In figure 10 the third trenches 163 have been etched down to expose the underlying layer of AlN pillars 141. The GaN of the sacrificial layer 140 may be further etched with selectivity to the AlN pillars 141 so as to allow for the pillars 141 to be exposed. The GaN embedding the pillars 141 may hence be at least partly removed so as to allow for the LED elements 11, 21, 31 to eventually be released from the substrate 170. The GaN may for example be etched in a plasma-based etch process, for example combining $O_2/Cl_2/Ar$, which has shown to be selective with regard to AlN.

The arrays of LED elements 11, 21, 31, which now are supported by portions or islands of GaN that have been cut out from the GaN sacrificial layer 140, may be attached or bonded to a carrier substrate 180 as shown in figure 11. The carrier substrate 180 may for example be a glass wafer 180 and may also be referred to as a stamp facilitating transfer of the LED elements 11, 21, 31 to a destination substrate (not shown). The pillars 141 may provide mechanical support of the LED elements 11, 21, 31 during the attaching of the carrier substrate 180, and may thus be considered as vertical tethers supporting the LED elements 11, 21, 31 which may be lattice-unmatched to the underlying substrate 170. Using vertical tethers 141 may advantageously reduce the complexity of a sacrificial release process of the LED elements 11, 21, 31 from the substrate 170. Reducing the mechanical tensions may reduce the risk for wafer bow of the substrate 170 for mass transfer. Wafer bow may make it difficult to efficiently attach all LED elements to the carrier substrate 180, and it is therefore desirable to reduce the wafer bow so as to increase the yield of the process of transferring the LED elements 11, 21, 31 to the carrier substrate 180.

GaN buffer interlayer 140 (and between nanopillars) may be relatively easy to remove (as shown in Fig 10) so as to release the LED elements 11, 21, 31 from the substrate 170. The result of such a process is shown in figure 12, wherein the GaN interlayer 140 have been removed by etching in an etch process. The etch process may for example be a plasma-based process, configured to etch GaN with a high selectivity to AlN pillars. Such can be achieved with a small addition of oxygen to a $Cl_2$-Ar plasma for example with an inductively coupled plasma reactor with a selectivity of 48:1, at a pressure 10 mTorr, a direct current bias of -150 V, and a power of 500 W, as described by Journal of Vacuum Science & Technology A 18, 879 (2000), incorporated herein as reference.

As shown in figure 12 the entire matrix 100 of LED elements 11, 21, 31 of different colour has now been transferred to the carrier substrate 180 and may be subject to subsequent processing steps employed in the fabrication of display devices, in which the LED elements 11, 21, 31 may form part of the pixels reproducing the images to be displayed on the display device. Alternatively, the pillars 141 may be kept under the LED elements 11, 21, 31. Preferably, the pillars 141 may be dimensioned so as to increase scattering of light from the LED elements 11, 21, 31.

With refence to figure 13 there is shown a schematic top-view of a matrix 100, which may be obtained in a method similar to the one outlined above in connection with figures 1-12. In the present example, the matrix 100 may comprise a monolithic structure of a plurality of LED elements of different colours, such as red LED elements 31, green LED elements 21 and blue LED elements 11, produced on the same substrate 170. Each of the colours may be arranged in a respective array, such as the first, second and third array discussed above, forming several RGB pixels to be used in a display device. Thus, each pixel may comprise one or several red, green and blue LED elements 11, 21, 31, wherein LED elements of the same colour may form a sub-pixel 10, 20, 30. A sub-pixel 10, 20, 30 may be understood as a controllable entity of a single colour and may in other words be formed of one or several LED elements of the first, second or third colour. In figure 13, as an illustrative and non-limiting example, 5x5 red LED elements 31 may be grouped into a red sub-pixel 30, 5x5 green LED elements 21 be grouped into a green sub-pixel 20, and a single blue LED element 11 forming a blue sub-pixel. The combination of sub-pixels 10, 20, 30 in the matrix 100 may be selected or varied depending on the difference in luminance between the colours and on the desired colour of the combined light emitted from the pixels. In the present example, half of the sub-pixels in each row of the matrix 100 may be red, whereas the green and blue sub-pixels may account for ¼ of the sub-pixels in each row.

Typically, the electroluminescence or luminance of the blue LED elements 11 may be higher than that of the green and red LED elements 21, 31. The green and the red LED elements 21, 31 may therefore be configured as quantum dots by means of Stranski-Krastanov growth mode during the epitaxy, or by selective area growth in individual openings or trenches below 4 nm in diameter or maximum width. Confining the InGaN layer laterally may improve the density of states for electroluminescence, and such a confinement may hence be achieved by forming quantum dots using several combined deposition and lithographic techniques, such as e.g. nanoimprint lithography or UV lithography combined with plasma-enhanced chemical vapor deposition as previously outlined in connection with figures 1-12.

The green and red sub-pixels 20, 30 may hence be formed by a plurality of relatively small second and third LED elements 21, 31, having a maximum lateral width below 10 nm, such as below 4 nm. In an example, the second LED elements 21, i.e. the green LED elements 21 in the present figure, may have a maximum lateral width of 2-3 nm, an indium composition corresponding to y being about 0.24 and a thickness of about 2.5 nm. The third LED elements 31, i.e. the red LED elements 31 in the figure, may have a maximum lateral width of 2.8-3.5 nm, and indium composition corresponding to z being about 0.30, and a thickness of about 3.1nm.

To balance the difference in luminance between the LED elements, the blue sub-pixels 10 may be formed by only a few first LED elements 11, such as a single first LED element 11 as shown in the present example. The single first LED element 11 may have a maximum lateral width corresponding to the width of the red or green sub-pixels and may in some examples be in the range of 5-25 μm. In a specific example, the first LED elements 11, i.e., the blue LED elements 11 may have a maximum lateral width of 15 μm, an indium composition corresponding to x being about 0.42 and a thickness of about 1.75 nm.

Each of the first, second and third arrays may be a 2D-array in which the respective first, second and third LED elements 11, 21, 31 may be arranged at regular or irregular intervals. As is readily appreciated by a person skilled in the art, and also illustrated in the example in figure 13, each array may define a series or arrangement of LED elements which may be ordered but not necessarily equidistant. Preferably, the arrays may be configured to interdigitate, or interleave, in a way that may results in a matrix comprising non-overlapping sub-pixels in line with the example shown in figure 13.

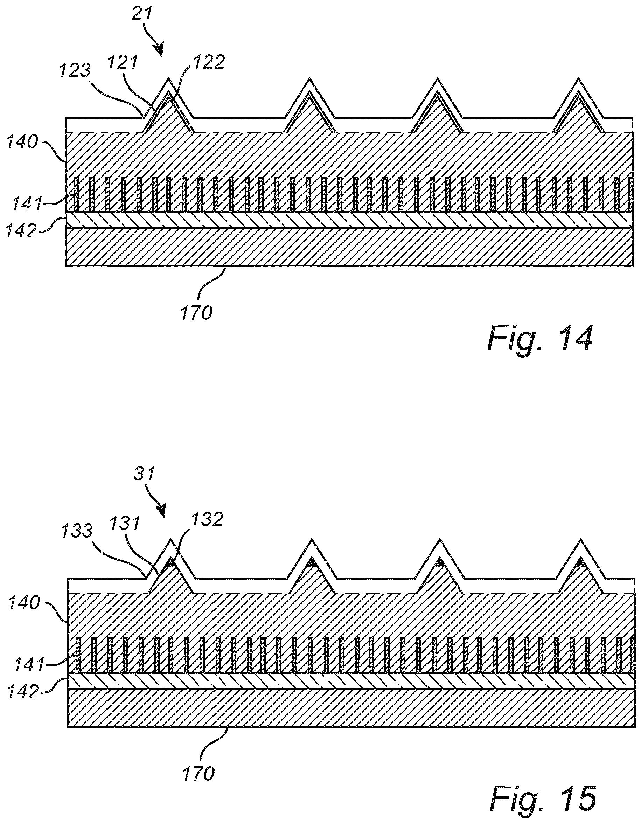

Figures 14-16 show a matrix according to some embodiments, which may be similarly configured as the embodiments shown in any of the previous figures 1-13. However, as indicated in figures 14-16 at least one of the first, second and third LED elements 11, 21, 31 may be formed on a non-planar structure, such as a polyhedron comprising a plurality of oblique surfaces. In figures 14-16 examples are shown of a pyramidal structure having three or four triangular side surfaces extending between a base and an apex. The pyramidal structure may be formed by the n-doped GaN 121 protruding from the GaN sacrificial layer 140. The stacked structure forming the LED elements, as outlined in connection with figure 2, may be arranged on the surfaces of the pyramidal structure. Preferably, the n-doped GaN 121 layer of the stacked structure may form the base of the pyramidal structure.

In figure 14, the InGaN layer 122 has been provided on the surfaces of the pyramidal structure of the n-doped GaN layer 121 and covered by the p-doped GaN layer 123. The quantum well may hence be arranged on the surfaces of the pyramidal structure. In figure 15, the InGaN layer 132 has been formed at the apex of the pyramidal structure and covered by the p-doped GaN layer 133. A sub-pixel as illustrated in figure 13 may hence be formed of a pyramid of an n-doped GaN layer 121, 131, an InGaN layer 122, 132 and a p-doped GaN layer 123, 133, wherein each of the pyramids may have the quantum wall provided either at its sidewalls or at its apex.

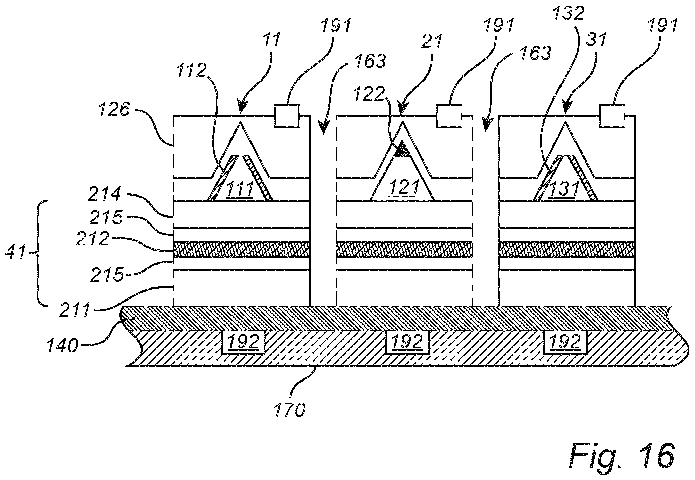

Figure 16 shows three examples of LED elements 11, 21, 31 which may be similarly configured as the LED elements outlined with reference to the previous figures. A few differences and variants will however be discussed in the following.

Firstly, the apex of the pyramidal structure may be truncated, for example by means of in situ etching, to increase uniformity. The result is shown in the first LED element 11 and the third LED element 31 in figure 16, wherein the respective InGaN layers 111, 131 extend along the lateral sides of the pyramidal structures but do not meet at the apex.

Secondly, as illustrated in the present figure, electrical contact structures 191, 192 may be provided for contacting the LED elements 11, 21, 31 according to any of the above-mentioned embodiments and examples. The electrical contacts may comprise a top contact 191 for contacting the LED elements 11, 21, 31 from above and a bottom contact 192 for contacting the LED elements 11, 21, 31 from below and thereby provide an electrical potential over the quantum confinement region formed by the InGaN layer(s). The top contact 191 may for example be formed in or on a transparent conducting oxide (TCO) 126, such as indium tin oxide, arranged above the stacked structure of the LED elements 11, 21, 31, whereas the bottom contact 192 may be provided as a buried interconnect structure arranged to contact the stacked structure from below. The first and second contacts 191, 192 may for example be formed of metal materials, including one or several of Ti, Al, Cu, Ni, and Au.

Thirdly, a fourth LED element 41 may be arranged below at least one of the first, second and third LED elements 11, 21, 31. In the example illustrated in figure 16 a fourth LED element is arranged below each of the first, second and third LED elements 11, 21, 31, and may be configured as an optical pump for the LED elements above. The fourth LED element 41 may be configured and processed in a similar manner as the LED elements 11, 21, 31 described with reference to any of the preceding embodiments, and the combined structure of the first, second and third LED elements 11, 21, 31 with a respective underlying fourth LED element 41 for optical pumping may be separated from each other by a set of third trenches 163 as described with reference to figure 10.

The fourth LED element 41 may hence comprise a stacked structure of an n-doped GaN layer 211 and a p-doped GaN layer 214 with an active, fourth InGaN layer 212 therebetween. The n-doped GaN layer 211 may for example be about 20 nm thick. The stacked structure may further comprise barrier layers, such as an undoped GaN layer 215 arranged directly adjacent the fourth InGaN layer 212. The undoped GaN layer 215 may for example be about 3 nm thick. In the present example, the stacked structure of the fourth LED element 41 may comprise an AlGaN barrier, such as a p-doped AlGaN layer 214, on which the n-doped GaN layer 111, 121, 131 of the stacked structures of the respective first, second and third LED elements 11, 21, 31 may be formed as outlined above. The AlGaN barrier layer 214 may for example be about 20 nm thick. It will be appreciated that the AlGaN barrier layer 214 may replace the GaN sacrificial layer 140 for the epitaxial growth of the n-doped GaN layer 111, 121, 131 of the first, second and third LED elements 11, 21, 31.

Similar to the InGaN layers of the first, second and third LED elements 11, 21, 31 the indium composition and the layer thicknes of the fourth $In_dGa_{(1-d)}N$ layer 212 may be varied to as to achieve a specific wavelength of the emitted light. Preferably, the fourth LED element 41 may be configured to emit light in the UV range, and may in some examples comprise an indium composition corresponding to d being less than 0.05. Additionally, in some examples, the layer thickness may be in the range of 1-6 nm.

In the above the inventive concept has mainly been described with reference to a limited number of examples. However, as is readily appreciated by a person skilled in the art, other examples than the ones disclosed above are equally possible within the scope of the inventive concept, as defined by the appended claims.

**Claims**

1. A microscopic light-emitting diode, microLED, structure comprising:
   a LED element (11, 21, 31) comprising:

   a base formed as a polyhedron comprising a base surface and a plurality of oblique surfaces extending between the base and an apex, the base being formed of GaN and constitutes a first GaN layer (111, 121, 131),
   a second GaN layer (113, 123, 133), and

an InGaN layer (112, 122, 132) arranged between the first GaN layer (111, 121, 131) and the second GaN layer (113, 123, 133), wherein the first GaN layer (111, 121, 131) is n-doped and the second GaN layer (113, 123, 133) is p-doped, or wherein the first GaN layer (111, 121, 131) is p-doped and the second GaN layer (113, 123, 133) is n-doped.

2. The microLED structure according to claim 1, wherein the LED element (11, 21, 31) further comprises AlGaN barrier layers (114) abutting the InGaN layer (112, 122, 132) on opposite sides thereof.

3. The microLED structure according to claim 2, wherein a 2-10 nm thick undoped GaN layer (115) is formed adjacent to one or both of the AlGaN barrier layers (114), such that an AlGaN layer (114) is arranged between the InGaN layer (112, 122, 132) and the undoped GaN layer 115, wherein the undoped GaN layer (115) preferably is abutting the AlGaN layer (114).

4. The microLED structure according to any one of claims 1-3, wherein the InGaN layer (112, 122, 132) is arranged on the plurality of oblique surfaces of the polyhedron.

5. The microLED structure according to any one of claims 1-3, wherein the InGaN layer (112, 122, 132) is arranged at the apex of the polyhedron.

6. The microLED structure according to any one of claims 1-5, wherein the LED element (11) is configured to emit blue light,

   wherein a maximum lateral width of the LED element (11) lies within the range of 0.1-1 $\mu$m, 2-5 $\mu$m or 5-25 $\mu$m,
   wherein the InGaN layer (112) has a thickness in the range of 0.5-3 nm, and/or
   wherein the InGaN layer (112) has an Indium content within the range of 0.10-0.75.

7. The microLED structure according to any one of claims 1-5, wherein the LED element (21) is configured to emit green light,

   wherein a maximum lateral width of the LED element (21) is 10 nm or less, such as within the range of 2-3 nm,
   wherein the InGaN layer (122) has a thickness in the range of 2-3 nm, and/or
   wherein the InGaN layer (122) has an Indium content within the range of 0.20-0.28.

8. The microLED structure according to any one of claims 1-5, wherein the LED element (31) is configured to emit red light,

   wherein a maximum lateral width of the LED element (31) is 10 nm or less, such as within the range of 2.8-3.5 nm,
   wherein the InGaN layer (132) has a thickness in the range of 2.8-3.5 nm, and/or
   wherein the InGaN layer (122) has an Indium content within the range of 0.28-0.33.

9. The microLED structure according to any one of claims 1-8, wherein a further LED element (41) is arranged below the LED element (11, 21, 31), wherein the further LED element (41) comprise a stacked structure of an n-doped GaN layer (211) and a p-doped GaN layer (214) with an InGaN layer (212) therebetween, wherein the further LED element (41) is configured as an optical pump for the LED element (11, 21, 31).

10. The microLED structure according to claim 9, wherein the Indium content of the InGaN layer (212) of the further LED element (41) is less than 0.05, and wherein the InGaN layer (212) of the further LED element (41) has a thickness of 1-6 nm.

11. The microLED structure according to any one of claims 1-10, further comprising a top contact (191) for contacting the LED element (11, 21, 31) from above and a bottom contact (192) for contacting the LED element (11, 21, 31) from below.

12. The microLED structure according to claim 11, wherein a transparent conducting oxide layer (126) is formed on the LED element (11, 21, 31), the transparent conducting oxide layer (126) abutting the second GaN layer (113, 123, 133), and wherein the top contact (191) is formed in or on the transparent conducting oxide layer (126).

13. A LED matrix (100) comprising a plurality of microLED structures according to any one of claims 1-12.

14. The LED matrix (100) according to claim 13, wherein the LED matrix (100) comprises LED elements (11, 21, 31) of different colours, such as red LED elements (31), green LED elements (21) and blue LED elements (11), wherein the LED elements (11, 21, 31) of a specific colour is arranged in a respective array, forming several RGB pixels to be used in a display device, wherein each RGB pixel preferably is formed of at least one of the blue LED elements (11), a plurality of green LED elements (21) and a plurality of and red LED elements (31).

15. The LED matrix (100) according to claim 13 or 14, wherein the plurality of microLED structures are monolithically arranged on a same support structure, wherein the support structure comprises a substrate (170), a pillar layer (142) comprising a plurality of vertical pillars (141) arranged on the substrate (170), and a GaN layer (140) embedding the vertical pillars (141), wherein the microLED structures are arranged on the GaN layer (140).

*Fig. 1*

*Fig. 2*

*Fig. 3*

11

140

141

142

170

## Fig. 4

11    161    151

140

141

142

170

## Fig. 5

11    21    151

140

141

142

170

## Fig. 6

*Fig. 7*

*Fig. 8*

*Fig. 9*

Fig. 10

Fig. 11

Fig. 12

16

Fig. 13

21

123  121  122

140

141

142

170

**Fig. 14**

31

133  131  132

140

141

142

170

**Fig. 15**

Fig. 16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *Journal of Vacuum Science & Technology A*, 2000, vol. 18, 879